# EUROPEAN PATENT APPLICATION

(11) **EP 4 502 205 A1**
(43) Date of publication of application: **05.02.2025**
(21) Application number: 23778786.6
(22) Date of filing: 25.01.2023
(51) Int. Cl.: C22C 9/06, C22C 9/00, C22C 9/02, C22C 9/04, C22C 9/05, C22C 9/10, C22F 1/00, C22F 1/08, H01B 1/02, H01B 5/02

(54) **STRIP-SHAPED COPPER ALLOY MATERIAL, SEMICONDUCTOR LEAD FRAME USING SAME, SEMICONDUCTOR INTEGRATED CIRCUIT AND ELECTRONIC DEVICE, AND METHOD FOR PRODUCING LEAD FRAME AND METHOD FOR USING STRIP-SHAPED COPPER ALLOY MATERIAL AS LEAD FRAME**

(30) Priority: 29.03.2022 JP 2022052880
(71) Applicant: JX Advanced Metals Corporation, Tokyo 105-8417 (JP)
(72) Inventor: NAKATSUMA Munehiko, Koza-gun, Kanagawa 253-0101 (JP)
(74) Representative: Wilson Gunn
(86) International application number: PCT/JP2023/002212
(87) International publication number: WO 2023/188748

(57) **Abstract**

A copper alloy material strip containing more than 0.1% by mass of Si, Ni, and the balance copper with inevitable impurities, and having a 0.2% yield strength of 550 MPa or more measured by the following method, and having the elongation after fracture of 10% or less measured by the following method after heating at 400°C for 30 minutes and being allowed to stand in an air atmosphere and being lowered to room temperature.

## Description

### [Field of the Invention]

The present invention relates to a copper alloy material strip suitable for use in a manufacture of electronic components such as electronic materials, a semiconductor lead frame using the same, a semiconductor integrated circuit and an electronic device, a method of manufacturing the lead frame, and a method of using the copper alloy material strip as the lead frame.

### [Background of the Invention]

In the related art, as a method of manufacturing a semiconductor package, a technique has been used to place semiconductor chips at predetermined positions on an individual lead frame, connect lead portions of the lead frame to the semiconductor chips with conductor wires, and seal the lead frame with resin. On the other hand, to improve production efficiency, a MAP (Mold Alley Process) method has been developed.

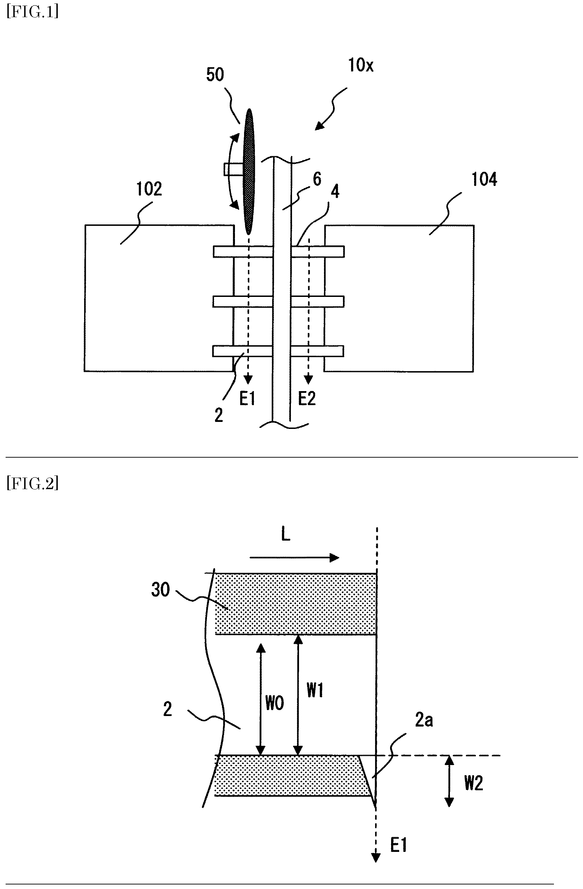

According to the MAP method, as shown in Fig. 1, a lead frame prototype 10x in which a plurality of lead portions 2, 4 of a product-shaped lead frame is connected vertically and horizontally via a connecting bar 6 is used. A plurality of semiconductor chips 102, 104 ... is placed at predetermined positions of the lead frame prototype 10x to electrically connect the respective lead portions 2, 4, and the whole is together sealed with resin. Then, the connecting bar 6 and respective lead portions 2, 4 are diced by a rotating blade 50 in cutting directions E1, E2 into individual pieces, thereby cutting into individual semiconductor package products.

In particular, the MAP method is suitably applied to a leadless structure with no lead is jutted out, which is called as a QFN (Quad Flat Non lead package) type semiconductor package.

In the lead frame, high strength is required for a copper alloy that is a material of the lead frame, and a technology to increase the strength of the copper alloy have been developed (Patent Literature 1).

### [Prior Art Literature]

### [Patent Literature]

[Patent Literature 1]: Japanese Patent Application Laid-open No. 2019-167612

### [Summary of the Invention]

### [Problems to be solved by the Invention]

Incidentally, as shown in Fig. 2, by dicing, the lead portion 2 sealed with resin 30 is cut together with the resin 30, so a cut surface along the cutting direction E 1 is in a form in which the resin 30 includes the lead portion. Then, a shape defect called a dicing burr 2a is often observed on a downstream side of the cutting direction E1 of the lead portion 2 on the cut surface. If the burr 2a at the tip of the lead portion 2 protrudes significantly more than the lead 2 itself and is in contacted with adjacent lead portions, there is a risk of short-circuiting a circuit.

In addition, a width W1 of the lead portion 2 is desired to be controlled within tolerance from a specified design width W0 (e.g., tolerance | W1-W0 | is less than ± 10% of W0). However, if the burr 2a at the tip of the lead portion 2 becomes large, a width W2 in that area greatly exceeds the tolerance, resulting in a defective product.

In view of the above, it is required to decrease the dicing burr. In particular, along with miniaturization of electronic components, the width and spacing of the lead portions tend to be smaller, and it is further required to decrease the dicing burr.

In other words, the present invention is made to solve the above problem, an object is to provide a copper alloy material strip which has high strength and suppresses burr generation at the time of cutting in a state of sealing with resin, a semiconductor lead frame using the same, a semiconductor integrated circuit and an electronic device, a method of manufacturing the lead frame, and a method of using the copper alloy material strip as the lead frame.

### [Means to solve the Problems]

As a result of various studies, the present inventors discovered that the dicing burr 2a shown in Fig. 2 is formed by an extension of the lead portion 2 on the cut surface in a cutting direction E1 perpendicular to its extension direction L due to shear force upon the dicing by applying a rotating blade in the cutting direction E1 perpendicular to the lead portion 2.

In addition, it is found that a ratio of the width of the burr W2 to the design width W0 upon the dicing in the cutting direction perpendicular to the lead portion is almost the same as an elongation after fracture of the copper alloy material itself when subjected to a heat treatment. As in the above-described QFN (Quad Flat Non lead package) type semiconductor package, for example, this is thought to be due to the fact that the lead portion is cut while constrained by the resin, and thus a mechanism similar to that of a tensile test of a copper material is at work.

When the copper alloy is used as the lead frame for a semiconductor package (hereinafter also simply referred to as a "semiconductor lead frame"), there is a die attach process to join islands and the semiconductor chips, where a plating layer is formed on the chip surface, and the plating layer and the islands are overlapped and heated at a temperature of about 400°C to join by thermal diffusion. Another die attach process is to solder the islands to the semiconductor chip, but in this case, the soldering temperature is also 300°C or more. Therefore, from a viewpoint of suppressing the dicing burr, it is found that it is necessary to control the elongation after fracture of the copper alloy concerned to be low even when the copper alloy is heated at 400°C for 30 minutes.

That is, a copper alloy material strip of the present disclosure is a copper alloy material strip containing more than 0.1% by mass of Si, Ni, and the balance copper with inevitable impurities, and having a 0.2% yield strength of 550 MPa or more measured by the following method, and having the elongation after fracture of 10% or less measured by the following method after heating at 400°C for 30 minutes and being allowed to stand in an air atmosphere and being lowered to room temperature,
wherein in the method of measuring the 0.2% yield strength, according to JIS-Z2241 (2011), the 0.2% yield strength(YS) is measured in a direction parallel with a rolling direction by the tensile testing machine, a JIS-13B test piece is prepared using a press machine such that a tensile direction is in parallel with the rolling direction, conditions of the tensile test are: a test piece width of 12.5 mm, room temperature (25°C), a tensile speed of 5 mm/min, and a gauge length of 50 mm, a test is conducted with a number of repetitions N = 2 (two test pieces), and an average of two data sets is used as the 0.2% yield strength of a sample,
wherein in the method of measuring the elongation after fracture, the JIS-13B test piece is prepared using the press machine such that the tensile direction is in parallel with the rolling direction, to prevent oxidation of surfaces of the test piece, the sample is packaged in a tough pitch copper foil with a thickness of 35 pm and the sample shielded from the outside air is heated at 400°C for 30 minutes in the air atmosphere, thereafter, the test piece is allowed to stand in the air atmosphere to lower the temperature of the copper alloy to room temperature (25°C), the elongation after fracture (%) specified in JIS-Z2241 (2011) is then measured by the tensile testing machine in accordance with JIS-Z2241 (2011), the conditions of the tensile test are: the test piece width of 12.5 mm, room temperature (25°C), the tensile speed of 5 mm/min, and the gauge length of 50 mm, the test is conducted with a number of repetitions N = 2 (two test pieces), and the average of the two data sets is determined as the elongation after fracture (%).

The copper alloy material strip of the present disclosure may forther contains one or more types of elements that form a compound with Si. Preferablly, the one or more types of elements that form the compound with Si are one or more types of elements selected from the group consisting of Co, Cr, Mn, Mg, and Fe.

Preferablly, the copper alloy material strip of the present disclosure contains more than 0.1% by mass of Si, and 0.5% by mass or more in total of the one or more types of elements that form the compound with Si.

Preferablly, the copper alloy material strip of the present disclosure contains more than 0.1% by mass to 1.8% by mass of Si, Ni, and 0.5 to 7.0 % by mass in total of the one or more types of elements that form the compound with Si.

Preferablly, the copper alloy material strip of the present disclosure contains Sn and/or Zn.

Preferablly, the copper alloy material strip of the present disclosure consists of a Cu-Ni-Si based copper alloy material.

Preferablly, the copper alloy material strip of the present disclosure consists of a Cu-Ni-Si based copper alloy material containing Ni: 2.2 to 4.2 % by mass, Si: 0.25 to 1.2 % by mass, Pb: less than 0.1 % by mass, Zn: less than 1.0 % by mass, Fe: less than 0.20 % by mass, Mn: less than 0.10 % by mass. Mg: 0.05 to 0.30 % by mass, and the balance Cu with inevitable impurities.

Preferablly, the copper alloy material strip of the present disclosure has a tensile strength of 800 MPa or more measured by the following method,
wherein a tensile strength (TS) is measured in the direction parallel with the rolling direction by the tensile testing machine according to JIS-Z2241 (2011), at that time, the JIS-13B test piece is prepared using the press machine such that the tensile direction is in parallel with the rolling direction, conditions of the tensile test are: the test piece width of 12.5 mm, room temperature (25°C), the tensile speed of 5 mm/min, and the gauge length of 50 mm, the test is conducted with a number of repetitions N = 2 (two test pieces), and the average of two data sets is used as the tensile strength (TS) of the sample.

Preferablly, the copper alloy material strip of the present disclosure has an electrical conductivity of 30% or more. Preferablly, the copper alloy material strip of the present disclosure is used for a semiconductor package manufactured by a MAP method.

A semiconductor lead frame of the present disclosure consists of the copper alloy material strip.

Preferablly, the semiconductor lead frame of the present disclosure includes a plurality of lead portions and connecting bars, wherein the plurality of lead portions are connected via the connecting bars.

A semiconductor integrated circuit of the present disclosure includes the semiconductor lead frame.

Preferablly, t he semiconductor integrated circuit of the present disclosure includes the semiconductor lead frame, a plurality of semiconductor chips, and conductor wires, wherein the semiconductor chips are electrically connected with the conductor wires.

An electronic device of the present disclosure uses the semiconductor integrated circuit.

A method of manufacturing a lead frame of the present disclosure is a method of manufacturing a lead frame uses a copper alloy material strip having a 0.2% yield strength of 550 MPa or more, and having the elongation after fracture of 10% or less after the copper alloy is heated at 400°C for 30 minutes and is allowed to stand in the air atmosphere and the temperature of the copper alloy is lowered to room temperature.

Preferablly, the method of manufacturing the lead frame of the present disclosure includes a step of etching the copper alloy material strip.

A method of using, as a lead frame, a copper alloy material strip of the present disclosure is a method of using, as a lead frame, a copper alloy material strip having a 0.2% yield strength of 550 MPa or more, and having the elongation after fracture of 10% or less after the copper alloy is heated at 400°C for 30 minutes and is allowed to stand in the air atmosphere and the temperature of the copper alloy is lowered to room temperature.

### [EFFECTS OF THE INVENTION]

According to the present invention, there can be obtained a copper alloy material strip which has high strength and suppresses burr generation at the time of cutting in a state of sealing with resin.

### [BRIEF DESCRIPTION OF THE DRAWINGS]

[Fig. 1] Fig. 1 shows a method of manufacturing a semiconductor package by a MAP method.
[Fig. 2] Fig. 2 is a partial enlarged view around a lead portion of Fig. 1.
[Fig. 3] Fig. 3 shows a relationship between a ratio of (tensile strength/electrical conductivity) and an elongation after fracture when measured at room temperature after a copper alloy is heated at 400°C for 30 minutes and allowed to stand in an air atmosphere and the temperature is lowered to room temperature (25°C) about samples of Example 1 and Comparative Example 1.

### [MODES FOR CARRYING OUT THE INVENTION]

As a copper alloy in an embodiment of the present invention, an alloy containing mainly copper can be used. In addition, as the copper alloy in the embodiment of the present invention, a corson alloy can also be used.

The colson alloy typically refers to a copper alloy containing Si and an element that forms a compound with Si (e.g., one or more of Ni, Co, and Cr). When a solution treatment and an aging treatment are performed on the colson alloy, Si and the element that forms the compound with Si form the compound, and the compound precipitates as second-phase particles in a matrix phase. The "element that forms the compound with Si" refers an element in which existence of the compound can be confirmed between Si and the element in a state diagram relating to Si and the element (which may be a binary state diagram or a multi-system state diagram such as a ternary state diagram). It is preferable that the "element that forms the compound with Si" is an element for which a state diagram with copper exists. This is because it is possible to contain a large amount of the element in the copper alloy. The "element that forms the compound with Si" is, for example, Ni, Co, Cr, Mn, Mg, Fe, etc.

It is preferable that the "element that forms the compound with Si" is an element that is dissolved in copper. This is because it is possible to contain a large amount of the element in the copper alloy. Examples of the element that forms the solid solution with copper contains, Ni, Co, Cr, Mn, Mg, and Fe, for example. Also, the "element that forms the compound with Si" may be a metal element. It is preferable that the copper alloy in the embodiment of the present invention contains more than 0.1% by mass of Si.

The copper alloy in the embodiment of the present invention can contain 1.8% by mass or less of Si.

It is preferable that the copper alloy in the embodiment of the present invention contains 0.5% by mass or more in total of one or more types of elements that form a compound with Si.

The copper alloy in the embodiment of the present invention can contain 7.0% by mass or less in total of one or more types of the elements that form the compound with Si.

The copper alloy in the embodiment of the present invention can contain 0.5% by mass or more in total of one or more types of the elements selected from the group consisting of Co, Cr, Mn, Mg, and Fe.

The copper alloy in the embodiment of the present invention can contain 7.0% by mass or less in total of one or more types of the elements selected from the group consisting of Co, Cr, Mn, Mg, and Fe.

As an example, the colson alloy is an alloy containing copper, Si, and one or more types of the elements selected from the group consisting of Ni, Co, and Cr. As another example, the colson alloy has a composition containing 0.5 to 4.5% by mass of Ni, more than 0.1% by mass to 1.4% by mass of Si, and the balance copper with inevitable impurities. As another example, the colson alloy has a composition containing 0.5 to 4.5% by mass of Ni, more than 0.1% by mass to 1.4% by mass of Si, 0.03 to 0.5% by volume of Cr, and the balance copper with inevitable impurities.

As still another example, the colson alloy has a composition containing 0.5 to 4.5% by mass of Ni, more than 0.1% by mass to 1.4% by mass of Si, 0.5 to 2.5% by volume of Co, and the balance copper with inevitable impurities.

As still another example, the colson alloy has a composition containing 0.5 to 4.5% by mass of Ni, more than 0.1% by mass to 1.3% by mass of Si, 0.5 to 2.5% by volume of Co, 0.03 to 0.5% by volume of Cr, and the balance copper with inevitable impurities.

As still another example, the colson alloy has a composition of a Cu-Ni-Si based copper alloy described later.

Other elements (e.g., Sn, Zn, etc.) may be added to the colson alloy as desired. It is common to add these other elements up to a total of about 5.0 % by mass. For example, as yet another example, the colson alloy has a composition containing 0.5 to 4.5 % by mass of Ni, 0.1 to 1.4 % by mass of Si, 0.01 to 2.0 % by mass of Sn, 0.01 to 2.0 % by mass of Zn, and the balance copper with inevitable impurities.

Hereinafter, the Cu-Ni-Si based copper alloy material according to one embodiment of the present invention will be described. Unless otherwise specified, % in an alloy composition of the present invention indicates % by mass.

First, the composition of the copper alloy material strip will be described. The Cu-Ni-Si based copper alloy material strip of an embodiment of the present invention contains Ni: 2.2 to 4.2 % by mass, Si: 0.25 to 1.2 % by mass, Pb: less than 0.1 % by mass, Zn: less than 1.0 % by mass, Fe: less than 0.20 % by mass, Mn: less than 0.10 % by mass, Mg: 0.05 to 0.30 % by mass, and the balance Cu with inevitable impurities.

### <Ni and Si>

Ni and Si form precipitated particles of a fine Ni₂Si based intermetallic compound by the aging treatment, and Ni and Si thus significantly increase the strength of the alloy. In addition, as a result of Ni₂Si precipitation during the aging treatment, electrical conductivity is improved.

When a Ni concentration is 2.2% or more or an Si concentration is 0.25% or more, it is easier to obtain the desired strength. When the Ni concentration is 4.2% or less or when the Si concentration is 1.2% or less, it is easier to obtain good electrical conductivity. Therefore, an Ni content should be 2.2 to 4.2% and an Si content should be 0.25 to 1.2%. Preferably, the Ni content should be 2.2 to 3.2% and the Si content should be 0.4 to 0.6%.

A ratio of Ni (% by mass)/Si (% by mass) is preferably 3 to 5.

### <Other elements>

Pb is preferably less than 0.1 % by mass from a viewpoint of improving hot workability.

Zn is an element that improves a solder heat resistance peeling property, and good electrical conductivity may be provided when the content of Zn is less than 1.0% by mass.

Fe is an element that contributes to strength, and good electrical conductivity may be provided when the content is less than 0.20% by mass.

Mn is an element that improves the hot workability, and good electrical conductivity may be provided when the content is less than 0.10% by mass.

Mg is an element that contributes to the strength. The good electrical conductivity may be provided when the content is 0.30 % by mass or less, and the strength can be further improved when the content is 0.05 % by mass or more.

### <Measurement of composition>

The composition of the copper alloy material strip can be measured by fluorescence X-ray analysis. Specifically, the fluorescence X-ray analysis is conducted using Simultix14 manufactured by Rigaku Corporation.

An analysis surface should be cut or mechanically polished so that maximum surface roughness Rz (JIS-B0601 (2013)) is 6.3 pm or less. When picking up an analysis sample from molten metal during melting and casting, the sample is cast into a shape of 30 to 40 mmΦ and a thickness of about 50 to 80 mm, and then cut into pieces having a thickness of about 10 to 20 mm, and the cut surface is used as the analysis surface.

The analysis surface is repeatedly cut or mechanically polished until the maximum surface roughness Rz (JIS-B0601 (2013)) is 6.3 pm or less.

Incidentally, the composition of the copper alloy material strip may be determined by wet analysis other than the fluorescence X-ray. With respect to Ni, a copper separation dimethylglyoxime gravimetric method (JIS-H1056 (2003)) may be used, and with respect to Si, the silicon dioxide gravimetric method (JIS-H1061 (2006)) may be used. With respect to other additive and impurity elements, an ICP optical emission spectrometry method may be used.

Specifically, an ICP optical emission spectrometer (ICP-OES) SPS3100 manufactured by Hitachi High-Tech Science Corporation is used for the measurement. In the case of the ICP optical emission spectrometry method, the sample is dissolved in a mixed acid of hydrochloric acid and nitric acid (hydrochloric acid 2, nitric acid 1, water 2) and is used by diluting. A common method of measuring each element in the ICP optical emission spectrometry method may refer to the JIS standard described below. Specifically, the ICP optical emission spectrometry may be conducted according to JIS-H1054 (2002) with respect to Fe, according to JIS-H1053 (2009) with respect to Pb, according to JIS-H1052 (2010) with respect to Sn, according to JIS-H1058 (2013) with respect to P, according to JIS-H1062 (2006) with respect to Zn, according to JIS-H1060 (2002) with respect to Co, and according to JIS-H1055 (2003) with respect to Mn.

### <0.2% yield strength>

The copper alloy of the present invention has a 0.2% yield strength of 550 MPa or more as specified in JIS-Z2241 (2011). When the 0.2% yield strength is less than 550 MPa, the lead portion may be deformed by a spray pressure during etching when manufacturing a lead frame. Also, when processing into a semiconductor package, the lead portion may be deformed due to a pressure from a wire bonding part or when embedding the resin into a mold.

From a viewpoint of further suppressing deformation of the lead portion, the 0.2% yield strength is preferably 630 MPa or more, and more preferably 750 MPa or more.

Incidentally, according to JIS-Z2241 (2011), the 0.2% yield strength(YS) is measured with respect to a JIS-13B test piece in a direction parallel with a rolling direction by a tensile testing machine at a tensile speed (a gauge length of 50 mm, the tensile speed of 5 mm/min) for a repetition number of times N = 2 (two test pieces), of which two data sets are averaged.

### <Elongation after fracture>

The copper alloy according to the embodiment of the present invention is shielded from the outside air in an atmosphere that prevents surface oxidation (non-oxidizing gas such as argon or nitrogen; or reducing gas such as argon or nitrogen mixed with hydrogen or the like) or is packaged in 35 pm copper foil to prevent oxidation. The copper alloy is heated at 400°C for 30 minutes in the air atmosphere and allowed to stand. After the temperature of the copper alloy drops to room temperature, a tensile test is conducted to measure the 0.2% yield strengthat room temperature (25°C), and the elongation after fracture is 10% or less. Here, the elongation means elongation after fracture (%) as specified in JIS-Z2241 (2011). Note that Annexes G and H of JIS are not applied.

When the elongation after fracture is 10% or less, in the semiconductor lead frame manufactured from the Cu-Ni-Si based copper alloy according to the embodiment of the present invention, generation of burr (dicing burr) can be suppressed upon cutting of the lead portion sealed with the resin in a direction perpendicular to its extension direction.

Here, the reason for the elongation after heating at 400°C for 30 minutes is based on the assumption that the temperature of the thermal diffusion method (about 400°C) is the highest temperature for electrically connecting the lead portion to the semiconductor chip, as described above.

In addition, the reason for setting an upper limit of the elongation after fracture to 10% is that, as already mentioned, the ratio of a protrusion amount of the dicing burr in the cutting direction of the lead portion to a design width is considered to be almost the same as the elongation of the copper alloy material strip subjected to a heat treatment (30 minutes at 400°C) assuming the lead portion.

In other words, if the upper limit of the elongation of the copper alloy material strip is 10%, the width W2 of the dicing burr (Fig. 2) of the lead portion in the semiconductor lead frame manufactured from the copper alloy material strip can be less than tolerance (± 10%) from the design width W0 of the lead portion.

The measurement of the elongation after fracture is an average of two data sets of the elongation after fracture (elongation after fracture (%) as specified in JIS Z2241 (2011)) in the tensile test with the repetition number of times of N = 2 (two test pieces).

### <Tensile strength TS and electrical conductivity>

The copper alloy material strip according to the embodiment of the present invention preferably has a tensile strength TS of 800 MPa or more. When the tensile strength TS is 800 MPa or more, the strength is further improved and deformation or the like of the lead frame can be prevented.

Since the heat generated by a current-carrying circuit such as the lead frame increases due to increased throughput of a semiconductor device with higher functionality, etc., the electrical conductivity of the copper alloy material strip is preferably 30% IACS or more, and more preferably 40% IACS. In order to suppress the elongation after fracture after heating at 400°C for 30 minutes, the electrical conductivity is preferably 51% IACS or less, more preferably 47% IACS or less, and even more preferably 43% IACS or less.

Example of a preferable range of the electrical conductivity includes 30 to 51% of IACS, 30 to 47% of IACS, 30 to 43% of IACS, 40 to 51% of IACS, and 40 to 47% of IACS.

The copper alloy material strip according to the embodiment of the present invention can be used in the form of a strip, a plate, a foil, etc. Here, the "strip" is a concept that includes a wide and elongated shape, a rectangle, an oblong, a square, and a quadrilateral.

### <Manufacture of copper alloy material strip >

The copper alloy material strip can usually be manufactured by hot rolling, cold rolling, the solution treatment, the aging treatment, finishing cold rolling, and strain relief annealing of an ingot in this order. The cold rolling before the solution treatment is not mandatory and may be conducted as needed. The cold rolling may be conducted after the solution treatment and before the aging treatment as necessary, or the solution treatment and the aging treatment may be conducted two or more times, respectively. Between each of the above processes, grinding, polishing, shot blasting, pickling, degreasing, etc. may be conducted as appropriate to remove an oxidation scale from the surface.

The solution treatment is the heat treatment in which a silicide such as an Ni-Si based compound, a Co-Si based compound, and a Cr-Si based compound is dissolved in a Cu matrix, and the Cu matrix is simultaneously recrystallized. The solution treatment can also be served as the hot rolling.

The aging treatment precipitates the silicide dissolved by the solution treatment as fine particles of an intermetallic compound mainly containing Ni₂Si, Co₂Si, and Cr₂Si. This aging treatment increases the strength and the electrical conductivity. The aging treatment can be conducted under the conditions, for example, at 375 to 625°C for 1 to 50 hours, which increases the strength.

If the temperature and the time of the aging treatment are less than the above ranges, a precipitation amount of the silicide such as Ni₂Si, Co₂Si, and Cr₂Si is small and sufficient strength (tensile strength, 0.2% yield strength, etc.) may not be obtained. If the temperature and the time of the aging treatment exceed the above ranges, coarsening and re-formation of the solid solution of the precipitated particles may occur, and the strength and the electrical conductivity may not be sufficiently improved. In the case where the temperature and the time of the aging treatment exceed the above ranges, a short aging time tends to result in high tensile strength but low electrical conductivity, while a high aging temperature tends to result in low both tensile strength and electrical conductivity due to re-formation of the solid solution.

### <Finishing cold rolling>

Next, after the aging treatment, the cold rolling (finishing cold rolling) may be conducted at a reduction ratio of 40% or more. The finishing cold rolling gives a residual strain by working to the material and increases the strength.

If the reduction ratio of the finishing cold rolling is less than 40%, it may be difficult to increase the strength sufficiently. The reduction ratio of the finishing cold rolling is preferably 40 to 90%. If the reduction ratio exceeds 90%, the electrical conductivity may decrease even though the strength is improved due to the residual strain by working by strong working.

The reduction ratio of the finishing cold rolling is a percentage change in thickness due to the finishing cold rolling relative to a material thickness immediately before the finishing cold rolling.

The thickness of the Cu-Ni-Si based copper alloy material strip of the present invention is not especially limited, but can be 0.03 to 0.6 mm, for example.

### < Strain relief annealing>

After the finishing cold rolling, the strain relief annealing is conducted. The strain release annealing may be conducted under general conditions, for example, at 300°C to 550°C and a holding time of 5 seconds to 300 seconds. However, after the strain relief annealing, the conditions should be such that the elongation measured at room temperature is less than 10%, preferably 7% or less, and more preferably 5% or less after the copper alloy is allowed to stand in the air atmosphere and the temperature is lowered to room temperature (25°C). By lowering the temperature or shortening the time in the strain relief annealing after the finishing cold rolling, the elongation after fracture when measured at room temperature can be further smaller after the copper alloy is allowed to stand in the air atmosphere and the temperature is lowered to room temperature (25°C). As described above, by controlling the elongation after fracture when measured at room temperature after the strain relief annealing and after the copper alloy is allowed to stand in the air atmosphere and the temperature is lowered to room temperature (25°C), the elongation after fracture is easily controlled to 10% or less after the copper alloy is heated at 400°C for 30 minutes and is allowed to stand in the air atmosphere and the temperature is lowered to room temperature (25°C).

In addition, as the conditions for the strain relief annealing, not only the temperature or time range is satisfied, but also a combination of temperature and time is selected with the following in mind.

In general, the strain relief annealing is conducted to improve stress relaxation properties, bendability, elongation, thermal expansion/shrinkage properties, or to decrease residual stress, but optimum conditions vary from purpose to purpose. In the embodiment of the present invention, even if the conditions are unfavorable in terms of improving the general stress relaxation properties, the bendability, the elongation, the thermal expansion/shrinkage properties, or decreasing the residual stress, the conditions are such that the elongation after fracture is less than 10%, preferably 7% or less, and more preferably 5% or less measured at room temperature after the strain relief annealing and after the copper alloy is allowed to stand in the air atmosphere and the temperature is lowered to room temperature (25°C).

In addition, in the strain relief annealing, it is important to suppress coarsening of precipitates by lowering the annealing temperature and/or shortening the time. Therefore, a difference ΔEL between the elongation after fracture before the strain relief annealing and the elongation after fracture after the strain relief annealing (= elongation after fracture after strain relief annealing (%) - elongation after fracture before strain relief annealing (%)) is used as an indication to evaluate and control a degree of growth of the precipitates. Also, the elongation after fracture before the strain relief annealing is measured at room temperature in a state that the copper alloy is at room temperature (25°C).

By being ΔEL 3.0% or less, coarsening of the precipitates can be decreased in the strain relief annealing. It thereby decreases coarsening of the precipitates when heated at 400°C for 30 minutes and controls the elongation after fracture to 10% or less when measured at room temperature after the copper alloy is heated at 400°C for 30 minutes and is allowed to stand in the air atmosphere and the temperature of the copper alloy is lowered to room temperature (25°C).

As the following information is used as a guideline, it can manufacture the copper alloy having the elongation after fracture of 10% or less measured at room temperature after the copper alloy is heated at 400°C for 30 minutes and is allowed to stand in the air atmosphere and the temperature of the copper alloy is lowered to room temperature (25°C).

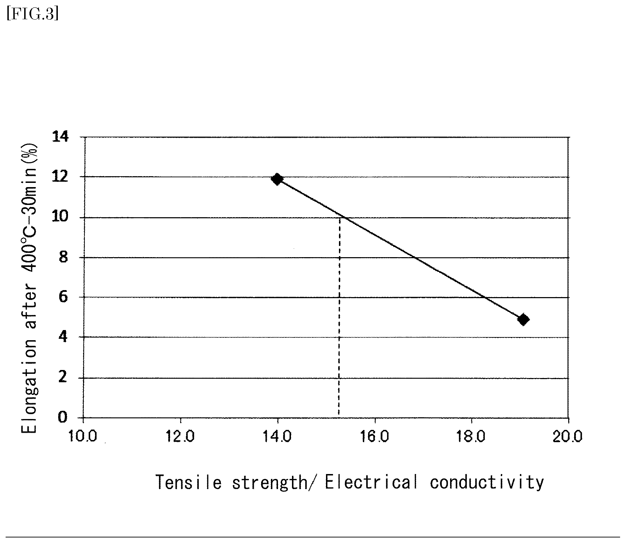

From Table 1 and Fig. 3 described later, a correlation is found between a value of (tensile strength/electrical conductivity), i.e., a value obtained by dividing the tensile strength (MPa) by the electrical conductivity (%IACS) and the elongation after fracture when measured at room temperature after the copper alloy is heated at 400°C for 30 minutes and is allowed to stand in the air atmosphere and the temperature of the copper alloy is lowered to room temperature (25°C). The tensile strength is an indicator of the extent to which fine precipitates and elements dissolved in copper are present in the copper alloy, which contribute to the increased strength and prevention of softening due to heating.

That is, it can be estimated that when the tensile strength is high, fine precipitates and elements dissolved in copper, which contribute to the increased strength and the prevention of softening due to heating, are high. Also, it can be estimated that when the tensile strength is low, fine precipitates and elements dissolved in copper, which contribute to the increased strength and the prevention of softening due to heating, are low.

Therefore, if the tensile strength is high, the elongation after fracture tends to be small when measured at room temperature after the copper alloy is heated at 400°C for 30 minutes and is allowed to stand in the air atmosphere and the temperature of the copper alloy is lowered to room temperature (25°C). If the tensile strength is low, the elongation after fracture tends to be large when measured at room temperature after the copper alloy is heated at 400°C for 30 minutes and is allowed to stand in the air atmosphere and the temperature of the copper alloy is lowered to room temperature (25°C).

In addition, the electrical conductivity is an indicator of the extent to which elements other than copper dissolved are present in the matrix phase of the copper alloy. It can be estimated that when the electrical conductivity is low, many elements other than copper are dissolved.

It can be estimated that when the electrical conductivity is high, less elements other than copper are dissolved. When many elements other than copper are dissolved, a lattice distortion increase, ductility is lowered, and the elongation after fracture tends to be small when measured at room temperature after the copper alloy is heated at 400°C for 30 minutes and is allowed to stand in the air atmosphere and the temperature of the copper alloy is lowered to room temperature (25°C). When less elements other than copper is dissolved, the lattice distortion decreases, the ductility is improved, and the elongation after fracture tends to be large when measured at room temperature after the copper alloy is heated at 400°C for 30 minutes and is allowed to stand in the air atmosphere and the temperature of the copper alloy is lowered to room temperature (25°C).

From the above, a higher value of tensile strength/conductivity means more fine precipitates contributing to the prevention of softening and more elements other than copper dissolved in the copper alloy. Therefore, the elongation after fracture tends to be small when measured at room temperature after the copper alloy is heated at 400°C for 30 minutes and is allowed to stand in the air atmosphere and the temperature of the copper alloy is lowered to room temperature (25°C).

A lower value of tensile strength/conductivity means less fine precipitates contributing to the prevention of softening and less elements other than copper dissolved in the copper alloy. Therefore, the elongation after fracture tends to be large when measured at room temperature after the copper alloy is heated at 400°C for 30 minutes and is allowed to stand in the air atmosphere and the temperature of the copper alloy is lowered to room temperature (25°C).

Therefore, the value of tensile strength/conductivity can be used as an indicator to control the elongation after fracture when measured at room temperature after the copper alloy is heated at 400°C for 30 minutes and is allowed to stand in the air atmosphere and the temperature of the copper alloy is lowered to room temperature (25°C). However, which value or more of tensile strength/conductivity that results in 10% or less of the elongation after fracture when measured at room temperature after the copper alloy is heated at 400°C for 30 minutes and is allowed to stand in the air atmosphere and the temperature of the copper alloy is lowered to room temperature (25°C) depends on the composition of the alloy, the order and number of times of each process after the solution treatment (i.e., the order and number of times of the aging treatment, the strain relief annealing and the like after the solution treatment).

Therefore, the copper alloy is first manufactured once by fixing the composition of the alloy and the order and number of times of each process after the solution treatment. Then, it is required to measure the value of tensile strength/conductivity and the value of the elongation after fracture when measured at room temperature after the copper alloy is heated at 400°C for 30 minutes and is allowed to stand in the air atmosphere and the temperature of the copper alloy is lowered to room temperature (25°C). Thereafter, the copper alloy is heated at 400°C for 30 minutes and is allowed to stand in the air atmosphere and the temperature of the copper alloy is lowered to room temperature (25°C), and a policy of whether to increase or decrease the value of tensile strength/electrical conductivity to obtain the elongation after fracture when measured at room temperature is determined.

Then, in order to adjust the value of tensile strength/electrical conductivity according to the policy, the conditions of the finishing cold rolling or the aging treatment are adjusted to increase or decrease the value of tensile strength/electrical conductivity with reference to the details described below. The value of elongation after fracture when measured at room temperature after the copper alloy is heated at 400°C for 30 minutes and is allowed to stand in the air atmosphere and the temperature of the copper alloy is lowered to room temperature (25°C) can then be controlled to the desired value by increasing or decreasing the value of tensile strength/electrical conductivity.

The tensile strength and the 0.2% yield strength are adjusted by the finishing cold rolling and the aging treatment after the solution treatment. If the reduction ratio of the finishing cold rolling is low, the tensile strength and the 0.2% yield strength are low. If the aging treatment is low (lower temperature and shorter time), the tensile strength and the 0.2% yield strength may be high.

In addition, the electrical conductivity is adjusted by the aging treatment. If the aging treatment is low (lower temperature and shorter time), the electrical conductivity may be low.

Fig. 3 shows a relationship between a ratio of (tensile strength/electrical conductivity) and the elongation after fracture when measured at room temperature after the copper alloy is heated at 400°C for 30 minutes and allowed to stand in the air atmosphere and the temperature is sufficiently lowered to room temperature (25°C) about samples of Example 1 and Comparative Example 1. Each is the common copper alloy with a composition having 2.3 mass% of Ni, 0.5 mass% of Si, 0.001 mass% of Pb, less than 0.02 mass% of Zn, 0.02 mass% of Fe, less than 0.005 mass% of Mn, 0.1 mass% of Mg, and the balance Cu with inevitable impurities. After the solution treatment in Example 1 and Comparative Example 1, the aging treatment, the finishing cold rolling, and the strain relief annealing were performed in this order. That is, the order and number of times of processes after the solution treatment are common in Example 1 and Comparative Example 1. A blend of each sample was measured by the fluorescence X-ray analysis described above.

By using Fig. 3 showing the relationship between the value of (tensile strength/electrical conductivity) and the elongation after fracture when measured at room temperature after the copper alloy is heated at 400°C for 30 minutes and allowed to stand in the air atmosphere and the temperature is sufficiently lowered to room temperature (25°C), the copper alloy having this composition is manufactured by the aging treatment, the finishing cold rolling, and the strain relief annealing after the solution treatment. It is found that by adjusting the value of (tensile strength/electrical conductivity) to about 15 or more, the elongation after fracture can be 10% or less when measured after the copper alloy is heated at 400°C for 30 minutes and is allowed to stand in the air atmosphere and the temperature of the copper alloy is sufficiently lowered to room temperature (25°C).

On the other hand, in a case where the composition is different or the order and number of times of each process after the solution treatment are different, a slope of the graph is assumed to be different from the slope in Fig. 3 by plotting the (tensile strength/electrical conductivity) as a horizontal axis and the value of the elongation after fracture as a vertical axis measured at room temperature (25°C) after the copper alloy is heated at 400°C for 30 minutes and is allowed to stand in the air atmosphere and the temperature of the copper alloy is sufficiently lowered to room temperature. In addition, it is also assumed that the value of (tensile strength/electrical conductivity), which can control the elongation after fracture to 10% or less when measured at 25°C after the copper alloy is heated at 400°C for 30 minutes and is allowed to stand in the air atmosphere and the temperature of the copper alloy is sufficiently lowered to room temperature, is different.

Therefore, in a case where the composition of the copper alloy is different or the order and number of times of each process after the solution treatment are different, the graph similar to Fig. 3 should be separately created.

Here, in a case where the order and number of times of each process after the solution treatment are different, the graph should be separately created, i.e., in a case where the order and number of times of each process after the solution treatment are the same, the graph should not be separately created. This is because the compound precipitated in the copper alloy is dissolved by the solution treatment. This is because, by the solution treatment, a solid solution state of the compound and the elements once returns to a predetermined state, i.e., a majority of the copper alloy returns to an α phase (phase in which the additive elements are dissolved in Cu). After the solution treatment, the aging treatment or a rolling treatment is conducted to obtain a precipitation state of predetermined fine precipitates or an element state in which predetermined elements are dissolved in the copper alloy, and predetermined properties are obtained.

### [Examples]

Samples of Example 1 and Comparative Example 1 were prepared using the composition and processes described above to manufacture copper alloy sheets with a thickness of 0.15 mm.

Differences in manufacturing conditions in each process between Example 1 and Comparative Example 1 are as follows.

In Example 1, the temperature and the time were adjusted within the above conditions so that the electrical conductivity would be 40% IACS or more during the aging treatment after the solution treatment. Here, in Example 1, the aging temperature was set lower than in Comparative Example 1 so as to increase the tensile strength and to decrease the electrical conductivity.

In Example 1, the reduction ratio was set in the finishing cold rolling such that the 0.2% yield strengthwas 550 MPa or more. Here, in Comparative Example 1, the aging temperature was such that the tensile strength was low and the electrical conductivity was high. Therefore, in the finishing cold rolling of Comparative Example 1, the reduction ratio was set to higher than in Example 1.

In addition, the strain relief annealing after the finishing cold rolling was performed on the conditions of ΔEL in Table 1.

### <Electrical conductivity (%IACS)>

The electrical conductivity (%IACS) of the obtained samples was measured at 25°C by a 4-terminal method according to JIS-H0505 (1975).

### <Tensile strength (TS)>

The tensile strength (TS) of the obtained samples was measured in the direction parallel with the rolling direction by the tensile testing machine according to JIS-Z2241 (2011). First, a JIS-13B test pieces was prepared from each sample using a press machine such that the tensile direction was the rolling direction. The conditions of the tensile test were as follows: a test piece width of 12.5 mm, room temperature (25°C), a tensile speed of 5 mm/min, and a gauge length of 50 mm. The test was performed with a number of repetitions N = 2 two test pieces), and the average of the two data sets was used as the tensile strength (TS) of the obtained sample.

### <0.2% yield strength>

The 0.2% yield strength(YS) in the direction parallel with the rolling direction was measured for the obtained samples by the tensile testing machine in accordance with JIS-Z2241 (2011).

First, the JIS-13B test piece was prepared from each sample using the press machine such that the tensile direction was the rolling direction. The conditions of the tensile test were as follows: the test piece width of 12.5 mm, room temperature (25°C), the tensile speed of 5 mm/min, and the gauge length of 50 mm. The test was performed with a number of repetitions N = 2 (two test pieces), and the average of the two data sets was used as the 0.2% yield strength of the obtained sample.

### <Elongation after fracture>

First, the JIS-13B test piece was prepared from each sample using the press machine such that the tensile direction was the rolling direction. To prevent oxidation of surface of the test piece, the sample was packaged in a tough pitch copper foil with a thickness of 35 µm and the sample shielded from the outside air was heated at 400°C for 30 minutes in the air atmosphere.

Thereafter, the test piece was allowed to stand in the air atmosphere to sufficiently lower the temperature of the copper alloy to room temperature (25°C). The elongation after fracture (%) specified in JIS-Z2241 (2011) was then measured by the tensile testing machine in accordance with JIS-Z2241 (2011).

The conditions of the tensile test were as follows: the test piece width of 12.5 mm, room temperature (25°C), the tensile speed of 5 mm/min, and the gauge length of 50 mm. The test was performed with a number of repetitions N = 2 (two test pieces), and the average of the two data sets was determined as the elongation after fracture (%) when the obtained sample was heated at 400°C for 30 minutes and then cooled to room temperature. Note that Annexes G and H of JIS -Z2241 (2011) were not applied.

### <Presence or absence of dicing burr>

For the obtained sample, the lead portion having a specified size was created, embedded in resin, and diced perpendicular to a direction in which the lead portion extends using a specified circular blade. If a blur size meets a customer standard, it is considered as good, and if it does not meet the customer standard, it is considered as poor. Considering a dimensional accuracy required for the lead frame, it can be said that dicing burr is well controlled if the burr size is 10% or less of the width of the lead portion. Therefore, according to the customer standard, it may also be determined to be good if the burr size is less than 10% of the width of the lead portion, and be defective if the burr size is more than 10% of the width of the lead portion.

The results obtained are shown in Table 1 and Fig. 3.

**[Table 1]**

| | Tensile strength (MPa) | 0.2% yield strength (MPa) | Electrical conductivity (%IACS) | Tensile strength/ Electrical conductivity | Elongation after fracture(%) | | | | Evaluation (dicing burr) |
|---|---|---|---|---|---|---|---|---|---|
| | | | | | Before strain relief annealing | Immediately after strain relief annealing | Δ EL | After 400°C-30 min | |
| Example1 | 857 | 830 | 45.0 | 19.0 | 3.2 | 3.4 | 0.2 | 4.9 | Good |
| Comp-Example1 | 703 | 618 | 50.4 | 13.9 | 5.9 | 9.3 | 3.4 | 11.9 | Poor |
| Example2 | 750 | 680 | 47.0 | 16.0 | 4.5 | 7.5 | 3.0 | 9.5 | Good |
| Example3 | 980 | 950 | 38.0 | 25.8 | 2.6 | 2.8 | 0.2 | 4.0 | Good |
| Example4 | 920 | 890 | 48.0 | 19.2 | 2.5 | 2.8 | 0.3 | 4.3 | Good |
| Example5 | 710 | 670 | 52.0 | 13.7 | 3.5 | 5.0 | 1.5 | 7.0 | Good |

As apparent from Table 1, evaluation of the dicing burr was good in the case of Example 1, where the elongation after fracture when measured at room temperature (25°C) was less than 10% after the copper alloy was heated at 400°C for 30 minutes and was allowed to stand in the air atmosphere and the temperature of the copper alloy was sufficiently lowered to room temperature.

On the other hand, the dicing burr was generated in the case of Comparative Example 1, where the elongation after fracture when measured at room temperature (25°C) exceeded 10% after the copper alloy was heated at 400°C for 30 minutes and was allowed to stand in the air atmosphere and the temperature of the copper alloy was sufficiently lowered to room temperature.

Here, in Example 1, since the strain relief annealing was performed under conditions where the ΔEL value was small, the elongation after fracture was almost the same level before and after the strain relief annealing, there was almost no increase in the elongation after fracture due to the strain relief annealing, and the value of the elongation after fracture was as low as less than 5%.

On the other hand, in Comparative Example 1, since the strain relief annealing was performed under conditions where the ΔEL value was large, the elongation was less than 10% before the strain relief annealing, but the elongation after fracture was significantly high after the strain relief annealing, reaching almost 10%. From this, it is apparent that Comparative Example 1 has a marked tendency to have a high elongation after fracture upon heating. The reason for this is that the ratio of (tensile strength/electrical conductivity) is smaller in Comparative Example 1 than in Example 1, which is considered to have a property that tends to increase plastic deformation capacity upon heating, such as the strain relief annealing and heating at 400°C for 30 minutes.

Note that the reason why the elongation after fracture when measured in the tensile test, when the 0.2% yield strength of Comparative Example 1 is measured at room temperature (25°C) after the copper alloy is heated at 400°C for 30 minutes and is allowed to stand in the air atmosphere and the temperature of the copper alloy is sufficiently lowered to room temperature, tends to be larger is considered to be that the aging treatment is conducted at a higher temperature than in Example, resulting in coarsening of the precipitated particles that are effective in preventing softening on heating and making it more susceptible to softening on heating.

It is also considered that the higher reduction ratio in the finishing cold process facilitated softening in the subsequent heat treatment.

From Fig. 3, the following is found: about the copper alloy having the composition of 2.3% by mass of Ni, 0.5% by mass of Si, 0.001% by mass of Pb, less than 0.02% by mass of Zn, 0.02% by mass of Fe, less than 0.005% by mass of Mn, 0.1% by mass of Mg, and the balance Cu with inevitable impurities and manufactured by the aging treatment, the finishing cold rolling, and the strain relief annealing performed in this order after the solution treatment, by adjusting the ratio of (tensile strength/electrical conductivity) to about 15 or more, the elongation after fracture when measured at room temperature (25°C) can be less than 10% after the copper alloy was heated at 400°C for 30 minutes and was allowed to stand in the air atmosphere and the temperature of the copper alloy was sufficiently lowered to room temperature.

Next, based on the data from Example 1 and Comparative Example 1, properties under various manufacturing conditions and copper alloy compositions are estimated and are shown in Table 1 as Examples 2 through 5. Example 2 is obtained when the aging treatment temperature is higher than in Example 1 and lower than in Comparative Example 1. However, this ratio varies depending on the composition of the copper alloy, the order and number of manufacturing processes, etc. Therefore, if the composition of the copper alloy and the order and number of manufacturing processes after the solution treatment are different, it is necessary to perform experiments to determine this ratio for each.

For Example 2, when the temperature of the aging treatment is higher than in Example 1 but lower than in Comparative Example 1, since the precipitated particles of a compound of Ni and Si are partially coarsened and thus no longer contribute to strength, the tensile strength and the 0.2% yield strength are lower than in Example 1.

On the other hand, since the precipitated particles of the compound of Ni and Si are not so coarsened as compared with Comparative Example 1, the tensile strength and the 0.2% yield strength are higher value than in Comparative Example 1. Also, since more Ni and Si dissolved in the matrix phase are precipitated than in Example 1, and the precipitation amount is lower than in Comparative Example 1, the electrical conductivity is higher than in Example 1 and lower than in Comparative Example 1.

In addition, when the temperature of the aging treatment is higher than in Example 1 but lower than in Comparative Example 1, since the precipitated particles of the compound of Ni and Si are partially coarsened and softened as compared in Example 1, the elongation after fracture when measured at room temperature (25°C) after the copper alloy is heated at 400°C for 30 minutes and is allowed to stand in the air atmosphere and the temperature of the copper alloy is lowered to room temperature, is a higher value than in Example 1.

On the other hand, the precipitated particles of the compound of Ni and Si are not so coarsened as compared with in Comparative Example 1, so they are not softened as compared with in Comparative Example 1. Therefore, the elongation after fracture when measured at room temperature (25°C) of the copper alloy heated at 400°C for 30 minutes and allowed to stand in the air atmosphere and the temperature is sufficiently lowered to room temperature, is a value smaller than in Comparative Example 1. From the above, in Example 2 obtained based on the results of Example 1 and Comparative Example 1, the value of (tensile strength/electrical conductivity) is controlled to 15 by adjusting the temperature of aging treatment as described above, so Example 2 has the value of elongation after fracture of 9.5% when measured at room temperature (25°C) of the copper alloy heated at 400°C for 30 minutes and allowed to stand in the air atmosphere and the temperature is sufficiently lowered to room temperature. Since, in Example 2, the elongation after fracture when measured in the tensile test is 9.5%, when the 0.2% yield strengthis measured at room temperature (25°C) after heating at 400°C for 30 minutes and the temperature is lowered to room temperature, it is assumed that the dicing burrs are well suppressed based on a mechanism of the generation of dicing burrs.

Here, Ni and Si form the intermetallic compound and are precipitated in the copper alloy. The higher the concentration of Ni and Si, the greater the amount of the intermetallic compound of Ni and Si is precipitated. It is considered that when the precipitation amount of the intermetallic compound of Ni and Si increases, a dislocation is restrained by the intermetallic compound of Ni and Si, thereby lowering the ductility.

Then, for the copper alloy with a higher concentration of Ni and Si than in Example 1, if it is manufactured in the same way as in Example 1, the ductility will be lower than in Example 1, so that the elongation after fracture when measured at room temperature (25°C) after the copper alloy is heated at 400°C for 30 minutes and is allowed to stand in the air atmosphere and the temperature of the copper alloy is sufficiently lowered to room temperature, is considered to be a value smaller than the elongation of 4.9% in Example 1.

For Mg, the ductility is considered to be lower as a result of increased lattice distortion because it is dissolved in the copper alloy.

Accordingly, Example 3 is obtained as an example that the copper alloy is manufactured similar to Example 1 using the copper alloy with higher concentrations of Ni, Si and Mg obtained based on the result of Example 1, i.e., the copper alloy having the composition containing 4.2% by mass of Ni, 1.0% by mass of Si, 0.05% by mass of Pb, 0.1% by mass of Zn, 0.03% by mass of Fe, 0.30% by mass of Mg, and the balance Cu with inevitable impurities. Since, in Example 3, the elongation after fracture when measured at room temperature (25°C) after the copper alloy is heated at 400°C for 30 minutes and is allowed to stand in the air atmosphere and the temperature of the copper alloy is sufficiently lowered to room temperature, is the smaller value than the elongation after fracture of 4.9% in Example 1, it is assumed that the dicing burrs are well suppressed based on the mechanism of the generation of dicing burrs.

The elements other than Ni that form the compound with Si form the intermetallic compound with Si and are precipitated in the copper alloy. The higher a total concentration of the elements that form the compound with Si and the concentration of Si, the greater the amount of the intermetallic compound of the elements that form the compound with Si and Si is precipitated. It is considered that when the precipitation amount of the intermetallic compound of the elements that form the compound with Si and Si increases, a dislocation is restrained by the intermetallic compound of the elements that form the compound with Si and Si, thereby lowering the ductility.

Then, for the copper alloy in which a part of Ni in Example 1 is replaced with the elements other than Ni that form the compound with Si, the total concentration of the elements that form the compound with Si is higher than the Ni concentration in Example 1, and the Si concentration is higher than in Example 1, if it is manufactured in the same way as in Example 1, the ductility will be lower than in Example 1, so that the elongation after fracture when measured at room temperature (25°C) after the copper alloy is heated at 400°C for 30 minutes and is allowed to stand in the air atmosphere and the temperature of the copper alloy is sufficiently lowered to room temperature, is considered to be a value smaller than the elongation of 4.9% in Example 1.

Accordingly, Example 4 is obtained as an example that the copper alloy is manufactured similar to Example 1 using the copper alloy with higher total concentrations of Ni, Si and Mg that are the elements that form the compound with Si and a higher concentration of Si obtained based on the result of Example 1, i.e., the copper alloy having the composition containing 1.8% by mass of Ni, 1.0% by mass of Co, 0.15% by mass of Cr, 0.6% by mass of Si, and the balance Cu with inevitable impurities.

In Example 4, the elongation after fracture when measured at room temperature (25°C) after the copper alloy is heated at 400°C for 30 minutes and is allowed to stand in the air atmosphere and the temperature of the copper alloy is sufficiently lowered to room temperaturem is the smaller value than the elongation after fracture of 4.9% in Example 4, and it is assumed that the dicing burrs are well suppressed based on the mechanism of the generation of dicing burrs.

Furthermore, based on the result of Example 1 and a mechanism of forming the precipitated particles in the intermetallic compound, Example 5 is obtained as an example that the copper alloy is manufactured similar to Example 1 using the copper alloy having the composition containing 1.6% by mass of Ni, 0.35% by mass of Si, and the balance Cu with inevitable impurities. Since the amount of Ni and Si added is less than in Example 1, the elongation after fracture before heating at 400°C for 30 minutes tends to increase compared to Example 1. On the other hand, since there are no elements other than Ni that form the compound with Si, there is little possibility of significant coarsening of the precipitated particles. Therefore, it is assumed that the elongation after fracture when measured at room temperature (25°C) after the copper alloy is heated at 400°C for 30 minutes and is allowed to stand in the air atmosphere and the temperature of the copper alloy is sufficiently lowered to room temperature, will not be so large, and the elongation after fracture will be less than 10.0%, and it is assumed that the dicing burrs are well suppressed based on the mechanism of the generation of dicing burrs.

The following is inferred from studies by the inventors on the relationship between the aging treatment and the finish cold rolling with respect to the elongation after fracture of copper alloy after the heat treatment.

When the temperature of the aging treatment is increased within the range of the aging treatment conditions described above, the precipitation particles effective in preventing softening on heating are coarsened, making it easier to soften on heating, and it is assumed that the elongation after fracture when measured at room temperature (25°C) after the copper alloy is heated at 400°C for 30 minutes and is allowed to stand in the air atmosphere and the temperature of the copper alloy is sufficiently lowered to room temperature, is large.

In other words, it is assumed that in the case where the temperature of the aging treatment is low with other conditions being the same, the elongation after fracture when measured at room temperature (25°C) after the copper alloy is heated at 400°C for 30 minutes and is allowed to stand in the air atmosphere and the temperature of the copper alloy is sufficiently lowered to room temperature, can be decreased.

Accordingly, it is assumed that in the case where the temperature of the aging treatment is low with other conditions being the same as in Example 1, even if the strength is improved over Example 1, the elongation after fracture when measured at room temperature (25°C) after the copper alloy is heated at 400°C for 30 minutes and is allowed to stand in the air atmosphere and the temperature of the copper alloy is sufficiently lowered to room temperature, can be 10% or less.

In addition, it is assumed that in the case where the time of the aging treatment is long within the range of the aging treatment conditions described above, the precipitated particles that are effective in preventing softening on heating are coarsened and are more susceptible to softening on heating, and the elongation after fracture when measured at room temperature (25°C) after the copper alloy is heated at 400°C for 30 minutes and is allowed to stand in the air atmosphere and the temperature of the copper alloy is sufficiently lowered to room temperature, is large. In other words, it is assumed that in the case where the time of the aging treatment is short with other conditions being the same, the elongation after fracture when measured at room temperature (25°C) after the copper alloy is heated at 400°C for 30 minutes and is allowed to stand in the air atmosphere and the temperature of the copper alloy is sufficiently lowered to room temperature, can be decreased.

Accordingly, it is assumed that in the case where the time of the aging treatment is short with other conditions being the same as in Example 1, even if the strength is improved over Example 1, the elongation after fracture when measured at room temperature (25°C) after the copper alloy is heated at 400°C for 30 minutes and is allowed to stand in the air atmosphere and the temperature of the copper alloy is sufficiently lowered to room temperature, can be 10% or less.

About the reduction ratio of the finishing cold rolling, it is considered that higher reduction ratio of the finishing cold rolling leads to strain accumulation and easier softening by the heat treatment.

In other words, it is assumed that in the case where the reduction ratio of the finishing cold rolling is low with other conditions being the same, the elongation after fracture when measured at room temperature (25°C) after the copper alloy is heated at 400°C for 30 minutes and is allowed to stand in the air atmosphere and the temperature of the copper alloy is sufficiently lowered to room temperature, can be decreased.

Accordingly, it is assumed that in the case where the reduction ratio of the finishing cold rolling is low with other conditions being the same as in Example 1, even if the strength is impared over Example 1, the elongation after fracture when measured at room temperature (25°C) after the copper alloy is heated at 400°C for 30 minutes and is allowed to stand in the air atmosphere and the temperature of the copper alloy is sufficiently lowered to room temperature, can be 10% or less.

In view of the above, there can be provided the copper alloy that has the desired strength and can maintain the elongation after fracture of 10% or less when subjected to the heat treatment.

## Claims

1. A copper alloy material strip containing more than 0.1% by mass of Si, Ni, and the balance copper with inevitable impurities, and having a 0.2% yield strength of 550 MPa or more measured by the following method, and having the elongation after fracture of 10% or less measured by the following method after heating at 400°C for 30 minutes and being allowed to stand in an air atmosphere and being lowered to room temperature,
wherein in the method of measuring the 0.2% yield strength, according to JIS-Z2241 (2011), the 0.2% yield strength(YS) is measured in a direction parallel with a rolling direction by the tensile testing machine, a JIS-13B test piece is prepared using a press machine such that a tensile direction is in parallel with the rolling direction, conditions of the tensile test are: a test piece width of 12.5 mm, room temperature (25°C), a tensile speed of 5 mm/min, and a gauge length of 50 mm, a test is conducted with a number of repetitions N = 2 (two test pieces), and an average of two data sets is used as the 0.2% yield strength of a sample,
wherein in the method of measuring the elongation after fracture, the JIS-13B test piece is prepared using the press machine such that the tensile direction is in parallel with the rolling direction, to prevent oxidation of surfaces of the test piece, the sample is packaged in a tough pitch copper foil with a thickness of 35 µm and the sample shielded from the outside air is heated at 400°C for 30 minutes in the air atmosphere, thereafter, the test piece is allowed to stand in the air atmosphere to lower the temperature of the copper alloy to room temperature (25°C), the elongation after fracture (%) specified in JIS-Z2241 (2011) is then measured by the tensile testing machine in accordance with JIS-Z2241 (2011), the conditions of the tensile test are: the test piece width of 12.5 mm, room temperature (25°C), the tensile speed of 5 mm/min, and the gauge length of 50 mm, the test is conducted with a number of repetitions N = 2 (two test pieces), and the average of the two data sets is determined as the elongation after fracture (%).

2. The copper alloy material strip according to claim 1, containing one or more types of elements that form a compound with Si.

3. The copper alloy material strip according to claim 2, wherein the one or more types of elements that form the compound with Si are one or more types of elements selected from the group consisting of Co, Cr, Mn, Mg, and Fe.

4. The copper alloy material strip according to claim 2 or 3, containing 0.5% by mass or more in total of the one or more types of elements that form the compound with Si.

5. The copper alloy material strip according to any one of claims 2 to 4, containing more than 0.1% by mass to 1.8% by mass of Si, Ni, and 0.5 to 7.0 % by mass in total of the one or more types of elements that form the compound with Si.

6. The copper alloy material strip according to any one of claims 1 to 5, containing Sn and/or Zn.

7. The copper alloy material strip according to claim 6, consisting of a Cu-Ni-Si based copper alloy material containing Ni: 2.2 to 4.2 % by mass, Si: 0.25 to 1.2 % by mass, Pb: less than 0.1 % by mass, Zn: less than 1.0 % by mass, Fe: less than 0.20 % by mass, Mn: less than 0.10 % by mass. Mg: 0.05 to 0.30 % by mass, and the balance Cu with inevitable impurities.

8. The copper alloy material strip according to any one of claims 1 to 7, having a tensile strength of 800 MPa or more measured by the following method,
wherein a tensile strength (TS) is measured in the direction parallel with the rolling direction by the tensile testing machine according to JIS-Z2241 (2011), at that time, the JIS-13B test piece is prepared using the press machine such that the tensile direction is in parallel with the rolling direction, conditions of the tensile test are: the test piece width of 12.5 mm, room temperature (25°C), the tensile speed of 5 mm/min, and the gauge length of 50 mm, the test is conducted with a number of repetitions N = 2 (two test pieces), and the average of two data sets is used as the tensile strength (TS) of the sample.

9. The copper alloy material strip according to any one of claims 1 to 8, having an electrical conductivity of 30% or more.

10. The copper alloy material strip according to any of claims 1 to 9, used for a semiconductor package manufactured by a MAP method.

11. A semiconductor lead frame consisting of the copper alloy material strip according to any one of claims 1 to 10.

12. The semiconductor lead frame according to claim 11, including a plurality of lead portions and connecting bars, wherein the plurality of lead portions are connected via the connecting bars.

13. A semiconductor integrated circuit, including the semiconductor lead frame according to claim 11 or 12.

14. The semiconductor integrated circuit according to claim 13, including the semiconductor lead frame, a plurality of semiconductor chips, and conductor wires, wherein the semiconductor chips are electrically connected with the conductor wires.

15. An electronic device using the semiconductor integrated circuit according to claim 13 or 14.

16. A method of manufacturing a lead frame by using a copper alloy material strip having a 0.2% yield strength of 550 MPa or more, and having the elongation after fracture of 10% or less after the copper alloy is heated at 400°C for 30 minutes and is allowed to stand in the air atmosphere and the temperature of the copper alloy is lowered to room temperature.

17. The method of manufacturing the lead frame according to claim 16, including a step of etching the copper alloy material strip.

18. A method of using, as a lead frame, a copper alloy material strip having a 0.2% yield strength of 550 MPa or more, and having the elongation after fracture of 10% or less after the copper alloy is heated at 400°C for 30 minutes and is allowed to stand in the air atmosphere and the temperature of the copper alloy is lowered to room temperature.
